# EUROPÄISCHE PATENTSCHRIFT

(11) **EP 3 750 180 B1**
(45) Veröffentlichungstag und Bekanntmachung des Hinweises auf die Patenterteilung: **20.04.2022**
(21) Anmeldenummer: 19706237.5
(22) Anmeldetag: 06.02.2019
(51) Int. Cl.: H01L 21/677, H01L 21/67

(54) **LADESCHLEUSE FÜR EINEN SUBSTRATBEHÄLTER UND VORRICHTUNG MIT EINER LADESCHLEUSE**
LOAD PORT FOR A SUBSTRATE CONTAINER AND DEVICE WITH A LOAD PORT
PORT DE CHARGEMENT POUR UN CONTAINEUR DE SUBSTRATS ET DISPOSITIF AVEC PORT DE CHARGEMENT

(30) Priorität: 07.02.2018 DE 102018102762
(43) Veröffentlichungstag der Anmeldung: 16.12.2020
(73) Patentinhaber: Beier, Uwe, 01458 Ottendorf-Okrilla (DE)
(72) Erfinder: Beier, Uwe, 01458 Ottendorf-Okrilla (DE)
(74) Vertreter: Riechelmann & Carlsohn Patentanwälte PartG mbB
(86) Internationale Anmeldenummer: PCT/DE2019/100123
(87) Internationale Veröffentlichungsnummer: WO 2019/154462

(56) Entgegenhaltungen:
- US-A- 4 663 009
- US-A- 5 044 871
- US-A1- 2016 035 596
- US-A1- 2017 025 290
- US-B1- 6 395 648
- US-B1- 6 454 519

## Beschreibung

Die Erfindung betrifft eine Ladeschleuse für einen Substratbehälter, eine Vorrichtung mit einer solchen Ladeschleuse und ein Verfahren zum Betrieb einer solchen Ladeschleuse.

Ladeschleusen aus dem Stand der Technik sind u. a. aus den Dokumenten US2017/0025290-A, US4663009, US6395648-B1 und US2016/0035596-A1 bekannt.

In der Halbleiterindustrie werden zur Aufbewahrung und zum Transport flacher Substrate, beispielsweise von Wafern, Substratboxen eingesetzt. In der Regel werden dabei standardisierte Substratboxen eingesetzt, die als "Front-opening unified pods" (FOUP) bezeichnet werden. Eine solche Substratbox weist ein Gehäuse auf, das einen Boden, eine Decke sowie Seitenwände aufweist. In einer Seitenwand ist eine Zugangsöffnung ausgebildet. Die Substratbox weist einen Deckel zum Verschließen der Zugangsöffnung auf. Im Innenraum des Gehäuses sind voneinander beabstandete Träger für mehrere Substrate ausgebildet. Die Träger können eine oder mehrere Kassetten in der Substratbox halten, wobei jede der Kassetten ein oder mehrere Substrate aufnehmen kann. Dabei liegen die Substrate in der Substratbox mit ihren Flächenseiten im Wesentlichen parallel zum Boden der Substratbox. Durch die geöffnete Zugangsöffnung können eine oder mehrere Kassetten in den Innenraum des Gehäuses eingebracht und aus dem Innenraum entnommen werden. Eine Ausführungsform einer solchen Substratbox ist in DE 198 82 568 B4 beschrieben. Einzelheiten zu den standardisierten Substratboxen sind in den Veröffentlichungen des Verbandes "Semiconductor Equipment and Materials International" beschrieben. Die Substratboxen sind in SEMI E47.1-0704 "Provisional Mechanical Specification for FOUPS Used to Transport and Store 300 mm Wafers" in der im Juli 2004 veröffentlichten Fassung beschrieben. Die Kassetten sind in SEMI G77-0699 (Reapproved 0706) "Specification for Frame Cassette for 300 MM Wafers" in der im Juni 2006 veröffentlichten Fassung beschrieben. In der Substratbox befinden sich die Substrate unter atmosphärischem Druck.

Prozessanlagen, mit denen die Wafer bearbeitet werden können, weisen in der Regel einen sogenannten Loadport auf, der auf die standardisierten Substratboxen abgestimmt ist. Ein solcher Loadport ist in DE 10 2004 062 591 A1 gezeigt. Der Loadport weist eine sich horizontal erstreckende Basisplatte auf, die eine Verbindungsplatte trägt, auf der die standardisierte Substratbox formschlüssig angeordnet werden kann. Der Loadport weist ferner eine Öffnung auf, durch die Substrate aus der geöffneten Substratbox in eine Schleuse überführt werden können und umgekehrt. Die Schleuse, die nicht Teil des Loadports ist, sondern in der Regel bereits zur Prozessanlage gehört, ermöglicht es, nach Verschluss der Öffnung die Atmosphäre, insbesondere Druck, Temperatur und/oder deren chemische Zusammensetzung, einzustellen. Auf diese Weise kann die Atmosphäre in der Schleuse an die Bedingungen angepasst werden, die in der Prozesskammer der Prozessanlage oder in der Substratbox vorliegen, so dass ein Transfer von Substraten zwischen der Substratbox und der Prozesskammer möglich ist, ohne die Atmosphäre in der Prozesskammer zu verändern. In der Prozesskammer kann die Bearbeitung des Substrates vorgenommen werden. Zum Transfer eines Substrates zwischen der Substratbox und der Schleuse ist eine erste Handhabungseinrichtung erforderlich. Zum Transfer eines Substrates zwischen der Schleuse und der Prozesskammer ist eine zweite Handhabungseinrichtung erforderlich. Die erste und zweite Handhabungseinrichtung sind in der Regel Roboter.

US 2006/0045663 A1 offenbart einen Loadport mit einer Basisplatte, die einen speziellen Mechanismus zum Öffnen und Schließen des als Tür bezeichneten Deckels der Substratbox aufweist. Der Mechanismus soll es ermöglichen, den Deckel um eine vertikale oder horizontale Achse zu drehen. Nach dem Entfernen des Deckels kann die Substratbox um eine horizontale Achse gedreht werden, so dass deren Zugangsöffnung an die Öffnung im Loadport angrenzt. Die Basisplatte kann in einem Gehäuse ausgebildet sein, das an einer Seitenwand eine Gehäuse-Tür aufweist, in der der Mechanismus für den Deckel der Substratbox ausgebildet ist. Das Gehäuse soll es ermöglichen, die Atmosphäre in dem Gehäuse mit einem Spülgas zu reinigen, so dass die Substrate, die in der Substratbox enthalten sind, nur einer kontrollierten Umgebung ausgesetzt sind. Das Spülgas tritt dabei durch die Öffnung im Loadport auch in die Schleuse ein. In der Praxis haben sich die Drehung der Substratbox auf der Basisplatte und das Gehäuse, das das Einführen eines Spülgases ermöglichen soll, bisher nicht durchgesetzt. Insbesondere erschwert das Gehäuse den Zugang zur Substratbox, deren Griffe von einem Bediener nicht mehr ohne weiteres erreichbar sind.

US 2006/0102237 A1 schlägt vor, auf eine Evakuierungskammer zu verzichteten, in der die Substrate, die sich bisher unter atmosphärischem Druck in der Substratbox befanden, unter Vakuum gesetzt werden, bevor sie in die Prozesskammer gelangen. Dazu sollen die Substrate unter Vakuum transportiert werden. Das erfordert jedoch Substratboxen, die luftdicht abgeschlossen sind. Diese Bedingung erfüllen die standardisierten Substratboxen nicht, so dass sich die in US 2006/0102237 A1 vorgeschlagenen Vakuum-Substratboxen in der Praxis nicht durchgesetzt haben. Selbst wenn die vorgeschlagenen Vakuum-Substratboxen eingesetzt werden, so muss die Prozessanlage dennoch eine als "Interface" bezeichnete Kammer aufweisen, in die das Substrat von der Substratbox überführt wird, bevor es nach dem Öffnen der mit einem Deckel verschließbaren Öffnung in die Prozesskammer gelangen kann.

Aufgabe der Erfindung ist es, die Nachteile nach dem Stand der Technik zu beseitigen. Es soll insbesondere eine Ladeschleuse für einen Substratbehälter angegeben werden, die den Transfer von Substraten zwischen den standardisierten Substratbehältern und der Prozesskammer ermöglicht, ohne dass die Substrate zunächst in eine Schleuse überführt werden müssen. Dabei soll der Zugang zu dem Substratbehälter nicht behindert werden. Ferner sollen eine Vorrichtung mit einer solchen Ladeschleuse und ein Verfahren zum Betrieb einer solchen Ladeschleuse angeben werden.

Diese Aufgabe wird durch die Merkmale der Ansprüche 1, 14 und 15 gelöst. Zweckmäßige Ausgestaltungen der Erfindungen ergeben sich aus den Merkmalen der Unteransprüche.

Nach Maßgabe der Erfindung ist eine Ladeschleuse für einen Substratbehälter zur Aufnahme flacher Substrate vorgesehen. Die Ladeschleuse weist eine Ladekammer zur Aufnahme des Substratbehälters auf, die einen Boden, eine Decke, eine Rückwand, eine Vorderwand, eine erste Seitenwand und eine zweite Seitenwand, die die Rückwand mit der Vorderwand verbinden, aufweist. In der Ladekammer ist eine Trägereinheit zur Aufnahme des Substratbehälters angeordnet. Die Ladekammer ist zum Öffnen der Ladekammer entlang einer Teilungsebene in einen ersten Teil und einen zweiten Teil teilbar, wobei die Teilungsebene in Richtung der Rückwand versetzt zur Vorderwand durch die erste Seitenwand, die zweite Seitenwand, den Boden und die Decke der Ladekammer verläuft.

Die Rückwand der Ladekammer ist versetzt zur Vorderwand angeordnet. Die Vorderwand der Ladekammer ist somit von dem Substratbehälter beabstandet, wenn dieser auf der Trägereinheit abgestellt ist. Die Anordnung der Teilungsebene versetzt zur Vorderwand sorgt dafür, dass ein Zugang zur Ladekammer leicht möglich ist. Die Ladekammer behindert weder das Abstellen des Substratbehälters auf der Trägereinheit noch die Entnahme des Substratbehälters von der Trägereinheit. Die erfindungsgemäße Ladeschleuse stellt sicher, dass standartisierte Subtratboxen als Subtratbehälter, insbesondere die in SEMI E47.1-0704 "Provisional Mechanical Specification for FOUPS Used to Transport and Store 300 mm Wafers" in der im Juli 2004 veröffentlichten Fassung, verwendet werden können. Neben den standardisierten Substratboxen können auch andere Substratboxen als Substratbehälter verwendet werden, beispielsweise FOUPS zur Verwendung und zur Lagerung von 450 mm Wafern. Die Teilungsebene ist vorzugsweise eine vertikale Ebene oder eine um einen Winkel von bis zu 45° zu einer vertikalen Ebene geneigte Ebene.

Der Substratbehälter weist vorzugsweise ein Gehäuse auf, das einen Boden, eine Decke sowie Seitenwände aufweist. Das Gehäuse weist Zugangsöffnung zur Einführung eines oder mehrerer Substrate in den Substratbehälter oder zur Entnahme eines oder mehrerer Substrate aus dem Substratbehälter auf. Vorzugsweise ist die Zugangsöffnung in einer Seitenwand des Substratbehälters ausgebildet. Der Substratbehälter weist einen Deckel zum Verschließen der Zugangsöffnung auf. Im Innenraum des Gehäuses sind vorzugsweise voneinander beabstandete Träger für mehrere Substrate ausgebildet. Bei dem Deckel kann es sich um eine Tür handeln. Der Ausdruck "geöffneter Substratbehälter" bezieht sich auf einen Substratbehälter mit offener Zugangsöffnung. Dabei ist der Deckel von dem Substratbehälter unter Öffnung der Zugangsöffnung abgenommen. Der Ausdruck "geschlossener Substratbehälter" bezieht sich auf einen Substratbehälter mit geschlossener Zugangsöffnung. Dabei ist der Deckel auf den Substratbehälter unter Verschluss der Zugangsöffnung aufgesetzt. Der geschlossene Substratbehälter kann druckdicht ausgelegt sein. Auf diese Weise können die in ihm enthaltenen Substrate vor Partikelkontamination geschützt sein. In dem geschlossenen Substratbehälter kann atmosphärischer Druck herrschen, wobei auch ein anderer Druck in dem Substratbehälter eingestellt sein kann. Zum lösbaren Verbinden des Deckels mit dem Substratbehälter kann ein Verriegelungsmechanismus vorgesehen sein.

Der Substratbehälter kann ein oder mehrere Substrate aufnehmen. Die Substrate sind flache Substrate, beispielsweise Wafer wie ein Silicium-Wafer. Unter dem Begriff "flaches Substrat" wird ein Körper verstanden, der in zwei Richtungen eines kartesischen Koordinatensystems eine größere Ausdehnung, typischerweise eine sehr viel größere Ausdehnung, als in der dritten Richtung des kartesischen Koordinatensystems aufweist. Mit anderen Worten, die Breite und Länge des flachen Substrates ist größer, typischerweise sehr viel größer, als dessen Höhe. Bei flachen Substraten mit im Wesentlichen kreisförmigen Querschnitt ist sein Radius größer als dessen Höhe. Ein flaches Substrat kann eine flächige Unterseite und/oder eine flächige Oberseite aufweisen, wobei bevorzugt sowohl die Unterseite als auch die Oberseite flächig ausgebildet sind. Vorzugsweise verlaufen die Unterseite und die Oberseite parallel und fluchtend zueinander.

Zum Öffnen der Ladekammer wird die Ladekammer in einen ersten Teil und einen zweiten Teil geteilt, wodurch die Ladekammer in ihren geöffneten Zustand überführt wird. Im geöffneten Zustand kann der Substratbehälter maschinell oder durch einen Bediener auf der Trägereinheit abgestellt werden oder von der Trägereinheit entnommen werden.

Die Ladekammer wird von der Rückwand, der Vorderwand, der ersten Seitenwand, der zweiten Seitenwand, dem Boden und der Decke begrenzt. Die Rückwand, die Vorderwand, die erste Seitenwand, die zweiten Seitenwand, der Boden und die Decke werden im Folgenden auch gemeinsam als Wände bezeichnet. Die Vorderwand liegt vorzugsweise der Rückwand gegenüber. Vorzugsweise ist die Ladeschleuse so an einer Prozessanlage, in der Substrate bearbeitet werden können, angeordnet, dass die Rückwand der Ladekammer an das Gehäuse der Prozessanlage angrenzt.

Zum Schließen der Ladekammer wird der zweite Teil zum ersten Teil hin bewegt, bis der zweite Teil an dem ersten Teil anliegt. Dadurch wird die Ladekammer in ihren geschlossenen Zustand überführt. Der erste Teil und der zweite Teil liegen im geschlossenen Zustand derart aneinander an, dass die Ladekammer gegen die Umgebung abgedichtet ist. Die Wände der Ladekammer weisen in der Teilungsebene bevorzugt Dichtungsmittel auf, so dass im geschlossenen Zustand der erste Teil und der zweite Teil dicht miteinander verbunden sind.

Das Öffnen und Schließen der Ladekammer kann von einem Bediener oder in automatisierter Weise vorgenommen werden.

Die Trägereinheit kann ein Basiselement mit einer Oberseite und einer Unterseite aufweisen. Dabei liegt die Oberseite vorzugsweise in einer horizontalen Ebene. Das Basiselement kann eine Basisplatte sein. Auf der Oberseite des Basiselementes kann eine Verbindungplatte angeordnet sein. Auf die Verbindungplatte kann der Substratbehälter mit seiner Unterseite abgesetzt werden. Die Verbindungsplatte kann so ausgebildet sein, dass zwischen der Unterseite des Substratbehälters und der Verbindungplatte eine formschlüssige Verbindung hergestellt werden kann. Die Trägereinheit kann Kupplungselemente aufweisen, um einen sicheren Sitz des Substratbehälters zu gewährleisten. Die Trägereinheit kann Positionierelemente aufweisen, beispielsweise Positionierpins, um die Positionierung des Substratbehälters auf der Trägereinheit zu erleichtern.

Es kann vorgesehen sein, dass die Ladeschleuse Druckeinstellmittel zur Einstellung des Druckes in der Ladekammer aufweist. Ist die Ladekammer im geschlossenen Zustand gegen die Umgebung abgedichtet, so kann der Druck in der Ladekammer mittels Druckeinstellmittel eingestellt werden. Der Druck, der in der Ladekammer mittels der Druckeinstellmittel eingestellt werden kann, kann sich vom Umgebungsdruck unterscheiden. Beispielsweise kann ein Unterdruck oder ein Überdruck eingestellt werden, z. B ein Unter- oder Überdruck, der sich um 0,1, 0,5, 1,0, 5,0, 10,0 bar vom Umgebungsdruck unterscheidet. Typischerweise wird der Umgebungsdruck atmosphärischer Druck sein. Im geöffneten Zustand wird somit in der Ladekammer atmosphärischer Druck als Umgebungsdruck herrschen. Wird nun die Ladekammer vom geöffneten in den geschlossenen Zustand überführt, so kann nach dem Verbinden des ersten mit dem zweiten Teil der Ladekammer nach dem Herstellen des geschlossenen Zustandes ein Druck eingestellt werden, der von dem atmosphärischen Druck abweicht. Soll die Ladekammer vom geschlossenen Zustand in den geöffneten Zustand überführt werden, so kann es notwendig sein, in der Ladekammer vor dem Öffnen einen Druck einzustellen, der dem Umgebungsdruck entspricht.

Zum Einstellen eines Unterdrucks oder eines Überdrucks kann in einer der Wände der Ladekammer, beispielsweise in der Rückwand, eine Öffnung ausgebildet sein, die mit einem Ventil zum Öffnen oder Schließen der Öffnung versehen ist. Zum Einstellen eines Unterdrucks kann die Ladekammer an eine Einrichtung zur Erzeugung eines Unterdrucks, beispielsweise ein Vakuumpumpe, über eine Leitung angeschossen sein. Zur Einstellung eines Überdruckes kann die Ladeschleuse an eine Einrichtung zur Erzeugung eines Überdrucks, beispielsweise einen Kompressor zur Erzeugung eines Druckgases, über eine Leitung angeschlossen sein. Die erfindungsgemäße Ladeschleuse kann einen oder mehrere Anschlüsse für Drucktechnik aufweisen. Die Anschlüsse ermöglichen die Einstellung eines vorgegebenen Druckes in der Ladekammer der Ladeschleuse.

Es kann vorgesehen sein, dass die erfindungsgemäße Ladeschleuse eine Einrichtung zum Anheben und Absenken der Trägereinheit in der Ladekammer aufweist. Bei der Einrichtung zum Anheben und Absenken der Trägereinheit kann es sich um eine Hubeinheit handeln. Mittels der Hubeinheit kann die Trägereinheit in der Ladekammer angehoben oder abgesenkt werden. Unter dem Begriff "Anheben" der Trägereinheit wird in einer Ausführungsform der Erfindung eine Bewegung der Trägereinheit entlang einer vertikalen Achse in Richtung der Decke der Ladekammer verstanden.

Unter dem Begriff "Absenken" wird in einer Ausführungsform der Erfindung eine Bewegung der Trägereinheit entlang einer vertikalen Achse in Richtung des Bodens der Ladekammer verstanden.

Zur Führung der Trägereinheit können ein oder mehrere Führungsmittel vorgesehen sein. Das oder die Führungsmittel können innerhalb und/oder außerhalb der Ladekammer angeordnet sein. Vorzugsweise ist das oder die Führungsmittel in der Ladekammer an deren Rückwand angeordnet. Zur Führung der Trägereinheit an dem oder den Führungsmitteln kann die Trägereinheit einen Schlitten aufweisen. Bei dem Führungsmittel kann es sich um eine Führungsschiene handeln. Der Schlitten kann auf der Führungsschiene in vertikaler Richtung beweglich angeordnet sein.

Im Boden der Ladekammer kann eine Durchführung für die Hubeinheit zum Anheben und Absenken der Trägereinheit angeordnet sein. Die Hubeinheit kann eine Hubstange aufweisen, die durch die Durchführung in die Ladekammer geführt ist. Die Durchführung ist zweckmäßigerweise abgedichtet. Die Hubeinheit kann mit einer Hubplatte zusammenwirken, auf der die Trägereinheit, beispielsweise die Unterseite des Basiselementes, aufliegt. Die Hubeinheit kann eine Führung aufweisen. Die Führung ist vorzugsweise außerhalb der Ladekammer angeordnet. Bei der Führung kann es sich um eine Führung für die Hubstange handeln. Die Führung ermöglicht eine vertikale Bewegung der Hubstange. Die Hubeinheit kann einen Hubantrieb aufweisen. Der Hubantrieb ist vorzugsweise außerhalb der Ladekammer angeordnet, er kann aber auch innerhalb der Ladekammer angeordnet sein. Der Hubantrieb kann eine Bewegung der Hubstange bewirken. Die Hubeinheit kann ein Anheben der Trägereinheit in vertikaler Richtung und ein Absenken der Trägereinheit in vertikaler Richtung bewirken. Anstelle einer Hubstange kann ein anderes Hubelement vorgesehen sein.

Die erfindungsgemäße Ladeschleuse kann eine Schleusenöffnung aufweisen. Die Schleusenöffnung soll einen Transfer eines Substrates aus der oder in die Ladeschleuse ermöglichen. Dazu kann eine Handhabungseinrichtung vorgesehen sein. Die Handhabungseinrichtung kann Teil einer Prozessanlage zur Bearbeitung des Substrates, beispielsweise einer Druckprozessanlage, sein. Vorzugsweise ist die Schleusenöffnung in der Rückwand der Ladekammer ausgebildet. Dabei ist sie bevorzugt fluchtet zu einer Öffnung im Gehäuse der Prozessanlage angeordnet, so dass die Handhabungseinrichtung über die Schleusenöffnung ein Substrat aus der Ladekammer der erfindungsgemäßen Ladeschleuse in die Prozessanlage und aus der Prozessanlage in die Ladekammer der erfindungsgemäßen Ladeschleuse einführen kann. Die Schleusenöffnung kann mittels eines Schleusenventils verschlossen sein. Zum Transfer eines Substrates aus der Ladekammer in die Prozessanlage und aus der Prozessanlage in die Ladekammer wird das Schleusenventil geöffnet. Um einen Druckausgleich in der Ladekammer zu verhindern, ist der Übergang zwischen der Schleusenöffnung in der Rückwand der Ladekammer und der Öffnung in der Prozessanlage zweckmäßigerweise gegen die Umgebung abgedichtet.

Die Ausdehnung der Schleusenöffnung in vertikaler Richtung ist vorzugsweise geringer als die Ausdehnung der Zugangsöffnung in vertikaler Richtung. Die Ausdehnung der Schleusenöffnung wird durch die horizontale und vertikale Ausdehnung eines Substrates bestimmt, dass sich in dem Substratbehälter befindet. Sind die Substrate flache Körper, so ist die Ausdehnung der Schleusenöffnung in vertikaler Richtung kleiner, typischerweise viel kleiner, als ihre Ausdehnung in horizontaler Richtung. Die Schleusenöffnung kann somit eine flache Öffnung sein. Die Schleusenöffnung kann beispielsweise schlitzförmig sein, wobei ihre größte Ausdehnung in der Horizontalen liegt.

Die Ladeschleuse kann eine Einrichtung zum Öffnen und Schließen des Substratbehälters aufweisen. Bei dieser Einrichtung kann es sich um eine Öffnungsmechanik handeln, mit der der Substratbehälter-Deckel von der Zugangsöffnung abgenommen und auf die Zugangsöffnung aufgesetzt werden kann. Es kann vorgesehen sein, dass die Öffnungsmechanik in der Ladekammer unterhalb oder oberhalb der Schleusenöffnung angeordnet ist, wobei sie vorzugsweise oberhalb der Schleusenöffnung angeordnet ist. Der Ausdruck "unterhalb" bezieht sich dabei auf eine Anordnung zwischen der Schleusenöffnung und dem Boden der Ladekammer. Der Ausdruck "oberhalb" bezieht sich dabei auf eine Anordnung zwischen der Schleusenöffnung und der Decke der Ladekammer. Mittels der Öffnungsmechanik kann der Substratbehälter-Deckel von dem Substratbehälter unter Öffnung der Zugangsöffnung abgenommen werden. Ferner kann die Öffnungsmechanik nach dem Öffnen der Zugangsöffnung den Substratbehälter-Deckel halten. Außerdem kann mittels der Öffnungsmechanik der Substratbehälter-Deckel auf den Substratbehälter unter Verschluss der Zugangsöffnung aufgesetzt werden. Ist ein Verriegelungsmechanismus zum lösbaren Verbinden des Substratbehälter-Deckels mit dem Substratbehälter vorgesehen, so weist die Öffnungsmechanik mittel zum Entriegeln und Verriegeln des Verriegelungsmechanismus auf. Das heißt, mittels der Öffnungsmechanik kann der Verriegelungsmechanismus entriegelt werden, bevor der Substratbehälter-Deckel von dem Substratbehälter angenommen wird. Außerdem kann mittels der Öffnungsmechanik der Verriegelungsmechanismus verriegelt werden, nachdem Substratbehälter-Deckels auf den Substratbehälter aufgebracht wird.

Die erfindungsgemäße Ladeschleuse kann eine erste Identifizierungseinrichtung zur Identifizierung eines Substratbehälters, der sich in der Ladekammer befindet, aufweisen. Vorzugsweise ist die erste Identifizierungseinrichtung an der Rückwand der Ladekammer oder an der Trägereinheit angeordnet. Bei der ersten Identifizierungseinrichtung kann es sich um einen oder mehrere Sensoren handeln. Die erste Identifizierungseinrichtung kann zur Bestimmung der Charge, zu der die in dem Substratbehälter befindlichen Substrate gehören, dienen. Die identifizierten Informationen zur Charge können genutzt werden, um die Substrate nach deren Entnahme aus dem Substratbehälter nachverfolgen zu können.

Die erfindungsgemäße Ladeschleuse kann eine zweite Identifizierungseinrichtung zur Identifizierung von Substraten, die sich in dem Substratbehälter befinden, aufweisen. Vorzugsweise ist die zweite Identifizierungseinrichtung an der Rückwand der Ladekammer angeordnet, besonders bevorzugt zwischen der Öffnungsmechanik und der Schleusenöffnung. Bei der zweiten Identifizierungseinrichtung kann es sich um einen oder mehrere Sensoren handeln. Mittels der zweiten Identifizierungseinrichtung können beispielsweise die Anwesenheit und/oder die Position der Substrate in dem geöffneten Substratbehälter bestimmt werden. Insbesondere ist eine Anwesenheitskontrolle mittels der zweiten Identifizierungseinrichtung vorteilhaft.

Die Hubeinheit ist vorzugsweise eine Hubeinheit zum Anheben oder Absenken der Trägereinheit in zumindest eine der folgenden Positionen:
- eine Öffnungs- und Verschlussposition, in der sich die Oberseite der Trägereinheit in einer Lage befindet, die es der Öffnungsmechanik ermöglicht, den Substratbehälter-Deckel eines Substratbehälters, der sich auf der Oberseite der Trägereinheit befindet, abzunehmen oder aufzusetzen;
- eine Transferposition, in der sich die Oberseite der Trägereinheit in einer Lage befindet, die einen Transfer eines Substrates aus einem oder in einen Substratbehälter ermöglicht, der sich auf der Oberseite der Trägereinheit befindet; und
- falls die Ladeschleuse eine Identifizierungseinrichtung aufweist, eine Identifizierungsposition, wobei sich in der Identifizierungsposition die Oberseite der Trägereinheit in einer Lage befindet, in der die Identifizierungseinrichtung ein Substrat in einem Substratbehälter, der sich auf der Oberseite der Trägereinheit befindet, identifizieren kann.

Es kann vorgesehen sein, dass sich ein Substrat in einer Transferposition befindet, wenn es (i) in horizontaler Richtung aus dem Substratbehälter entnommen und durch die Schleusenöffnung geführt werden kann, und zwar ohne Veränderung seiner Lage in vertikaler Richtung, oder wenn es (ii) in horizontaler Richtung durch die Schleusenöffnung geführt und in den Substratbehälter auf einem freien Träger abgelegt werden kann, und zwar ohne Veränderung seiner Lage in vertikaler Richtung

Mittels der Hubeinheit kann somit ein verschlossener Substratbehälter, der sich auf der Oberseite der Trägereinheit befindet, zunächst in die Öffnungs- und Verschlussposition befördert werden, in der mittels der Öffnungsmechanik der Deckel abgenommen wird, um die Zugangsöffnung des Substratbehälters zu öffnen. Falls eine Identifizierungseinrichtung vorgesehen ist, kann der geöffnete Substratbehälter anschließend in die Identifizierungsposition befördert werden, in der Substrate, die sich in dem geöffneten Substratbehälter befinden, identifiziert werden. Von der Identifizierungsposition kann der geöffnete Substratbehälter dann in eine Transferposition überführt werden, in der mittels einer Handhabungseinrichtung ein Substrat aus dem geöffneten Substratbehälter entnommen oder in den Substratbehälter eingeführt werden kann. Der Substratbehälter kann jedoch auch direkt von der ersten in die Transferposition überführt werden. Aus einer Transferposition für den Transfer eines ersten Substrates kann der geöffnete Substratbehälter anschließend in eine andere Transferposition für den Transfer eines anderen Substrates überführt werden.

Es kann vorgesehen sein, dass für jedes Substrat, das aus dem geöffneten Substratbehälter entnommen oder in den geöffneten Substratbehälter eingebracht werden soll, eine gesonderte Transferposition vorgesehen ist. Das ist insbesondere dann zweckmäßig, wenn die Schleusenöffnung schlitzförmig ist. Insbesondere in diesem Fall ist es bevorzugt, den Substratbehälter mittels der Hubeinheit so zu positionieren, dass das Substrat, das aus dem Substratbehälter entnommen werden soll, sich in Höhe der Schleusenöffnung befindet, so dass das Substrat mittels der Handhabungseinrichtung in horizontaler Richtung aus dem Substratbehälter entnommen und durch die Schleusenöffnung geführten werden kann, und zwar ohne Veränderung seiner Lage in vertikaler Richtung. Das gilt auch entsprechend, wenn ein Substrat durch die Schleusenöffnung in den geöffneten Substratbehälter eingebracht werden soll. Der Substratbehälter wird dann mittels der Hubeinheit so positioniert, dass sich ein freier Träger, der das Substrat in dem Substratbehälter halten soll, in Höhe der Schleusenöffnung befindet, so dass das Substrat mittels der Handhabungseinrichtung in horizontaler Richtung durch die Schleusenöffnung geführt und in den Substratbehälter auf den freien Träger abgelegt werden kann, und zwar ohne Veränderung seiner Lage in vertikaler Richtung. Der freie Träger wird von einem Nutzer oder in automatisierter Weise vorgegeben. Es kann somit für jeden Transfer eines Substrates eine gesonderte Transferposition vorgesehen sein.

Mittels der Hubeinheit kann somit ein verschlossener Substratbehälter, der sich auf der Oberseite der Trägereinheit befindet, zunächst in die Öffnungs- und Verschlussposition befördert werden, in der mittels der Öffnungsmechanik der Deckel vom Substratbehälter abgenommen wird, um die Zugangsöffnung des Substratbehälters zu öffnen. Falls eine Identifizierungseinrichtung vorgesehen ist, kann der geöffnete Substratbehälter anschließend in die Identifizierungsposition befördert werden, in der Substrate, die sich in dem geöffneten Substratbehälter befinden, identifiziert werden. Von der Identifizierungsposition kann der geöffnete Substratbehälter dann in die Transferposition überführt werden, in der mittels einer Handhabungseinrichtung Substrate aus dem geöffneten Substratbehälter entnommen oder in den Substratbehälter eingeführt werden können. Der Substratbehälter kann jedoch auch direkt von der Öffnungs- und Verschlussposition in die Transferposition überführt werden.

Mittels der Hubeinheit kann ein geöffneter Substratbehälter, der sich auf der Oberseite der Trägereinheit befindet, von der Transferposition oder Identifizierungsposition in die Öffnungs- und Verschlussposition befördert werden. In der Öffnungs- und Verschlussposition kann der offene Substratbehälter mittels der Öffnungsmechanik verschlossen werden, indem der Deckel auf den Substratbehälter aufgesetzt wird.

Die erfindungsgemäße Ladeschleuse ist vorzugsweise so ausgelegt, dass ein automatisches Einbringen und Entnehmen von Substratbehältern in die Ladekammer möglich ist. Das automatische Einbringen und Entnehmen von Substratbehältern in die Ladekammer kann beispielsweise mittels autonomer Fahrzeuge und/oder Transportsysteme möglich sein. Die Fahrzeuge und/oder Transportsysteme können einen Transport von Substratbehältern zur Ladeschleuse und von der Ladeschleuse weg bewirken.

Nach Maßgabe der Erfindung ist ferner eine Vorrichtung zum Bearbeiten von flachen Substraten vorgesehen, die
- eine Prozesskammer zur Bearbeitung eines oder mehrerer flacher Substrate;
- eine erfindungsgemäße Ladeschleuse; und
- eine Handhabungseinrichtung zum Transfer eines oder mehrerer Substrate zwischen einem Substratbehälter, der von der Trägereinheit aufgenommen ist, und der Prozesskammer durch die Schleusenöffnung der Ladekammer;
aufweist. Die erfindungsgemäße Vorrichtung stellt eine Prozessanlage zur Bearbeitung flacher Substrate dar. In der Prozesskammer ist vorzugsweise ein Druck eingestellt, der sich vom Umgebungsdruck, der in der Regel atmosphärischer Druck ist, unterscheidet. In diesem Fall stellt die erfindungsgemäße Vorrichtung eine Druckprozessanlage dar.

Weist die erfindungsgemäße Ladeschleuse eine Schleusenöffnung auf, die in der Rückwand der Ladekammer ausgebildet ist, so ist die Schleusenöffnung vorzugsweise fluchtet zu einer Öffnung im Gehäuse der Prozessanlage angeordnet. Mittels der Handhabungseinrichtung kann dann über die Schleusenöffnung ein Substrat aus der Ladekammer der erfindungsgemäßen Ladeschleuse in die Prozessanlage und/oder aus der Prozessanlage in die Ladekammer der erfindungsgemäßen Ladeschleuse eingeführt werden. Die Handhabungseinrichtung kann statt eines Substrates jedoch auch zwei oder mehre Substrate führen. In diesem Fall ist eine Schleusenöffnung erforderlich, deren vertikale Ausdehnung den Transfer von zwei oder mehr Substraten zulässt.

Die erfindungsgemäße Vorrichtung kann mehr als eine, beispielsweise zwei, drei oder mehr erfindungsgemäße Ladeschleusen aufweisen.

Nach der Maßgabe der Erfindung ist außerdem ein Verfahren zum Betrieb einer erfindungsgemäßen Ladeschleuse vorgesehen, das die Schritte umfasst:
(a) Öffnen der Ladekammer durch Teilen in den ersten und den zweiten Teil;
(b) Absetzen eines Substratbehälters auf der Trägereinheit;
(c) Schließen der Ladekammer durch Zusammenfügen des ersten und des zweiten Teils;
(d) Abnehmen des Deckels des Substratbehälters mittels einer Öffnungsmechanik; und
(e) Entnahme zumindest eines Substrates aus dem Substratbehälter;
wobei zur Ausführung der Schritte (d) und (e) die Trägereinheit mittels einer Hubeinheit zum Anheben oder Absenken der Trägereinheit von
- einer Öffnungs- und Verschlussposition, in der sich die Oberseite der Trägereinheit in einer Lage befindet, die es der Öffnungsmechanik ermöglicht, den Substratbehälter-Deckel eines Substratbehälters, der sich auf der Oberseite der Trägereinheit befindet, abzunehmen oder aufzusetzen; in
- eine Transferposition, in der sich die Oberseite der Trägereinheit in einer Lage befindet, die einen Transfer eines Substrates aus einem oder in einen Substratbehälter ermöglicht, der sich auf der Oberseite der Trägereinheit befindet.
bewegt wird und wobei nach dem Öffnen des Substratbehälters in der Ladekammer ein Druck eingestellt wird, der sich von dem atmosphärischen Druck unterscheidet. Weitere Einzelheiten des erfindungsgemäßen Verfahrens sind vorstehend im Zusammenhang mit der erfindungsgemäßen Ladeschleuse beschrieben worden. Insbesondere kann, falls die Ladeschleuse eine Identifizierungseinrichtung aufweist, die Trägereinheit mittels einer Hubeinheit in eine Identifizierungsposition angehoben oder abgesenkt werden, wobei sich in der Identifizierungsposition die Oberseite der Trägereinheit in einer Lage befindet, in der die Identifizierungseinrichtung ein Substrat in einem Substratbehälter, der sich auf der Oberseite der Trägereinheit befindet, identifizieren kann.

Die Erfindung ermöglicht im Vergleich zum Stand der Technik bedeutende Einsparungen. Die Erfindung ermöglicht den Verzicht auf eine gesonderte Schleuse. In der Erfindung sind der aus dem Stand der Technik bekannte Loadport und die Schleuse nicht getrennt. Die erfindungsgemäße Ladeschleuse kann somit die Funktionen des Loadports und der Schleuse vereinen. Die erfindungsgemäße Ladeschleuse ist somit kompakter als die bisher erforderliche Kombination aus Loadport und Schleuse. Es ist deshalb leichter möglich, mehrere Ladeschleusen nebeneinander an einer Vorrichtung zur Bearbeitung von flachen Substraten platzsparend anzuordnen. Ebenso ist eine erfindungsgemäße Vorrichtung möglich, bei der mehrere Ladeschleusen und mehrere Prozesskammern platzsparend angeordnet sind.

Außerdem benötigt die erfindungsgemäße Vorrichtung zum Bearbeiten von Substraten nur eine Handhabungseinrichtung zum Transfer von Substraten zwischen dem Substratbehälter und der Prozesskammer. Nach dem Stand der Technik waren zwei Handhabungseinrichtungen erforderlich, eine erste zum Transfer zwischen Loadport und Schleuse und eine zweite zum Transfer zwischen Schleuse und Prozesskammer. Weil die erfindungsgemäße Vorrichtung die erfindungsgemäße Ladeschleuse aufweist, ist nur die zweite Handhabungseinrichtung erforderlich, um das Substrat zwischen dem Substratbehälter und der Prozesskammer zu bewegen. Die erfindungsgemäße Vorrichtung kann eine Prozesskammer und eine Handhabungseinrichtung aufweisen, die gegenüber dem Stand der Technik unverändert sind. Das ist insbesondere für bestehende oder zumindest bekannte Bearbeitungsprozesse vorteilhaft.

Die Erfindung spart somit Platz, was insbesondere in Reinräumen von hoher Bedeutung ist. Die Investitionskosten und die Betriebskosten sinken erheblich. Von Vorteil ist auch, dass eine Bedienung der erfindungsgemäßen Ladeschleuse und damit der erfindungsgemäßen Vorrichtung aus der Perspektive eines Bedieners unverändert bleibt. Bedienung und Ablauf sind im Wesentlichen gleich. Außerdem wird mit der Erfindung eine Erhöhung der Prozesssicherheit erreicht. Das ist insbesondere auf die geringe Zahl an Komponenten, die verringerte Zahl an Übergabestellen für das Substrat sowie weniger Substrathandling zurückzuführen. Die Verfolgung der Substrate in der erfindungsgemäßen Vorrichtung wird vereinfacht, das Leerfahren der erfindungsgemäßen Vorrichtung wird ebenfalls vereinfacht. Es ist nur eine einzige Druckanpassung pro Substratbox erforderlich, was energetisch günstig ist und eine Zeiteinsparung bedeutet. Es sind immer alle Substrate eines Substratbehälters gleichzeitig für die Prozessierung verfügbar, was Vorteile bietet für eine chargenbezogene Verarbeitung, die Prozesssicherheit und die Durchlaufzeiten. Schließlich wird eine geringere Partikelbelastung erreicht, da deutlich weniger Komponenten im Einsatz sind.

Die erfindungsgemäße Ladeschleuse ist zur Aufnahme standardisierter Substratbehälter, beispielsweise FOUPs, geeignet. Standardisierte Substratboxen helfen den Bedienern Fehler zu vermeiden, erleichtern die Anlagenbedienung und den Transport von Substraten. Sie schützen die Substrate vor Beschädigungen.

Die Erfindung wird nachstehend anhand von Ausführungsbeispielen, die die Erfindung nicht einschränken sollen, unter Bezugnahme auf die Zeichnungen näher erläutert. Dabei zeigen
- Fig. 1: einen Substratbehälter gemäß des Standes der Technik;
- Fig. 2: schematische Ansichten einer Ausführungsform einer erfindungsgemäßen Ladeschleuse im geschlossenen Zustand (Fig. 2a: Ansicht von oben; Fig. 2b: Ansicht von vorn);
- Fig. 3: schematische Ansichten der in Fig. 2 gezeigten Ausführungsform einer erfindungsgemäßen Ladeschleuse im offenen Zustand (Fig. 3a: Ansicht von oben; Fig. 3b: Ansicht von vorn);
- Fig. 4: eine perspektivische Darstellung insbesondere der Ladekammer der in Fig. 2 gezeigten Ausführungsform der erfindungsgemäßen Ladeschleuse;
- Fig. 5: eine schematische Darstellung einer erfindungsgemäßen Vorrichtung zur Bearbeitung flacher Substrate;
- Fig. 6: eine schematische Darstellung einer Ausführungsform einer erfindungsgemäßen Ladeschleuse zur Veranschaulichung des erfindungsgemäßen Verfahrens, wobei sich ein Substratbehälter in der Öffnungs- und Verschlussposition befindet;
- Fig. 7: eine weitere schematische Darstellung einer Ausführungsform einer erfindungsgemäßen Ladeschleuse zur Veranschaulichung des erfindungsgemäßen Verfahrens, wobei sich ein Substratbehälter in der Transferposition befindet; und
- Fig. 8: vereinfachte Darstellungen einer Ausführungsform einer erfindungsgemäßen Ladeschleuse zur Veranschaulichung des erfindungsgemäßen Verfahrens.

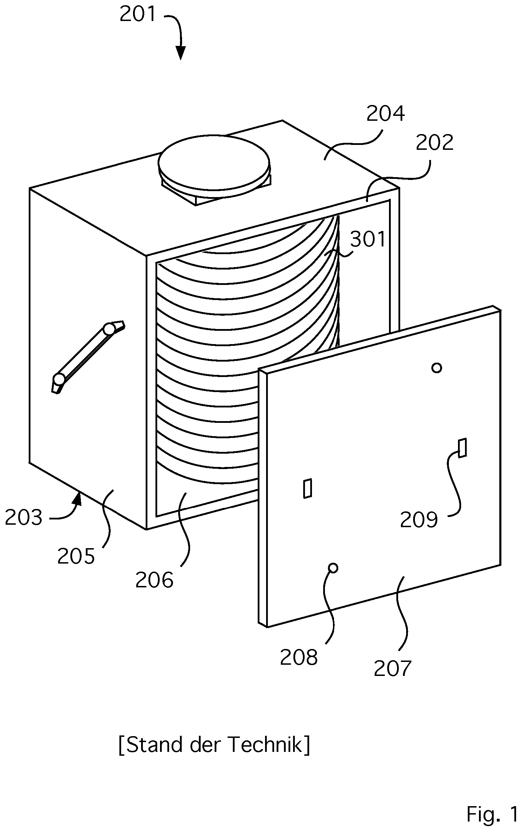

Fig. 1 zeigt einen Substratbehälter 201 mit einem Gehäuse 202, das einen Boden 203, eine Decke 204 sowie Seitenwände 205 aufweist. Das Gehäuse 202 weist eine Zugangsöffnung 206 auf, über die Substrate 301 in den Substratbehälter 201 eingeführt werden können und über die Substrate aus dem Substratbehälter 201 entnommen werden können. Die Zugangsöffnung ist an der Vorderseite des Gehäuses 202 ausgebildet. Zum Verschließen der Zugangsöffnung 206 ist ein Deckel 207 vorgesehen, der in Fig. 1 bereits von der Zugangsöffnung entfernt worden ist, so dass Fig. 1 einen geöffneten Substratbehälter zeigt. An zwei sich gegenüberliegenden Seitenwänden 205 sind Griffe ausgebildet, die das Abstellen und Aufnehmen des Substratbehälters 201 erleichtern sollen. An der Außenseite des Deckels 207 sind Positionierungsstifte 208 und Ausnehmungen 209 ausgebildet. Die Positionierungsstifte 208 ermöglichten die Positionierung des Deckels 207 an der Öffnungsmechanik 31. Die Ausnehmung 209 ermöglicht ein mechanisches Zusammenwirkung mit der Öffnungsmechanik 31, um den Deckel 207 von dem Gehäuse 202 unter Öffnung des Substratbehälters 201 abnehmen und ihn an dem Gehäuse 202 unter Verschluss des Substratbehälters 201 anbringen zu können. Bei dem Substratbehälter kann es sich um einen Standard-Substratbehälter gemäß SEMI E47.1-0704 "Provisional Mechanical Specification for FOUPS Used to Transport and Store 300 mm Wafers" handeln.

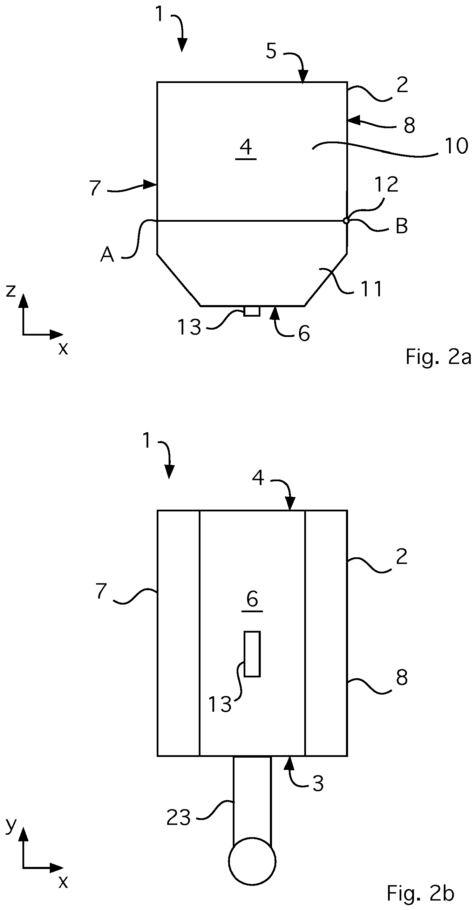

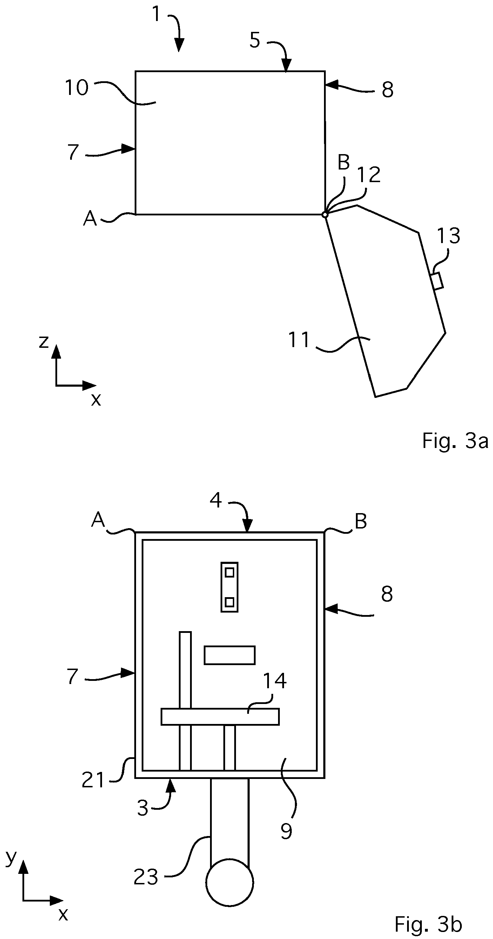

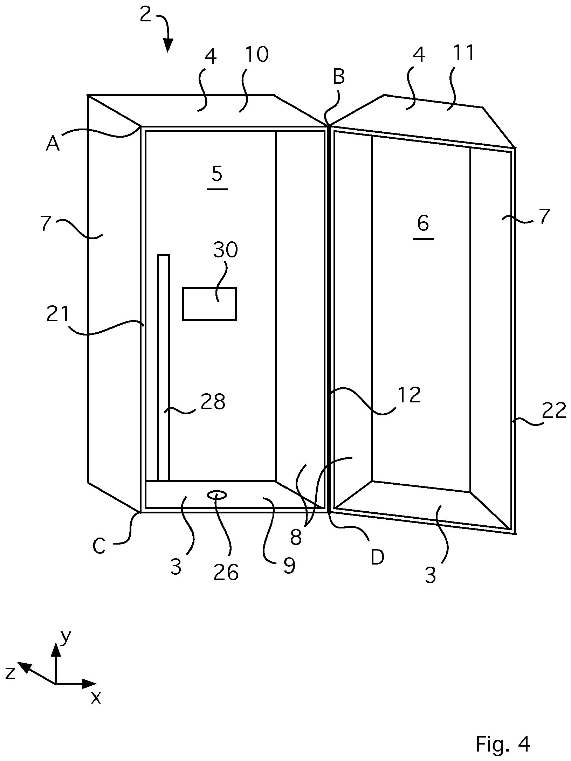

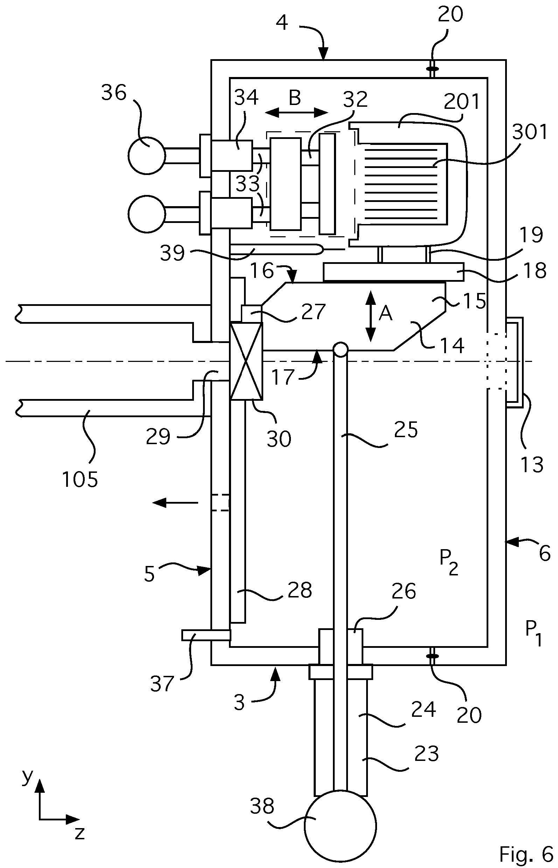

Die Figuren 2 und 3 zeigen eine Ausführungsform der erfindungsgemäßen Ladeschleuse 1. Die Ladeschleuse 1 weist eine Ladekammer 2 auf, die einen Boden 3, eine Decke 4, eine Rückwand 5, eine Vorderwand 6, eine erste Seitenwand 7 und eine zweite Seitenwand 8 aufweisen, die einen Innenraum 9 begrenzen. Dabei liegen sich die Rückwand 5 und die Vorderwand 6 gegenüber. Die Rückwand 5 und die Vorderwand 6 sind über die erste und zweite Seitenwand 7, 8 miteinander verbunden. Die Ladekammer 2 ist in einen ersten Teil 10 und einen zweiten Teil 11 teilbar. Die Teilungsebene verläuft in einer vertikalen Ebene an den Punkten A, B, C und D in den Figuren 2 bis 4 (x,y-Ebene eines kartesischen Koordinatensystems). Die Teilungsebene verläuft dabei in Richtung der Rückwand versetzt zur Vorderwand durch die erste Seitenwand 7, die zweite Seitenwand 8, den Boden 3 und die Decke 4 der Ladekammer 2. Der erste Teil 10 der Ladekammer 2 weist eine umlaufende Kante 21 auf, die im geschlossen Zustand der Ladekammer 2 an einer umlaufender Kante 22 des zweiten Teils 11 druckdicht anliegt. Dazu sind an der gesamten Kante 21 des ersten Teils 10 und/oder an der gesamten Kante 22 des zweiten Teils 11 Dichtungsmittel 20 vorgesehen (siehe auch Fig. 6). Der erste Teil 10 und der zweite Teil 11 sind an einer vertikalen Achse, die durch die Punkte B und D der Teilungsebene verläuft und auf der y-Koordinate liegt, über ein Gelenk 12 miteinander verbunden. Zum Öffnen der Ladekammer 2 wird der zweite Teil 11 mittels des Gelenkes 12 um die vertikale Achse B-D geschwenkt. Dabei wird der erste Teil 10 vom zweiten Teil 11 getrennt, so dass der erste Teil 10 an seiner Kante 21 der zweite Teil 11 an seiner Kante 22 freiliegt. Um das Öffnen und Schließen der Ladekammer 2 zu erleichtern, kann ein Griff 13 an der Außenseite der Vorderwand 6 angebracht sein.

Im Innenraum 9 der Ladekammer 2 befindet sich eine Trägereinheit 14. Die Trägereinheit 14 weist ein Basiselement 15 (siehe Fig. 6) mit einer Oberseite 16 und einer Unterseite 17 auf. Dabei liegt die Oberseite 16 in einer horizontalen Ebene. Auf der Oberseite 16 des Basiselementes 15 ist eine Verbindungplatte 18 angeordnet. Auf die Verbindungplatte 18 kann der Substratbehälter 201 mit seiner Unterseite, dem Boden 203, abgesetzt werden. Zur Positionierung des Substratbehälters 201 auf der Verbindungsplatte 18 sind an ihrer Oberseite Positionierpins 19 vorgesehen, die die Positionierung des Substratbehälters 201 auf der Trägereinheit 14 in einer vorgegebenen Position erleichtern. Der Innenraum 9 der Ladekammer 2 ist so bemessen, dass der Boden 3, die Decke 4, die Rückwand 5, die Vorderwand 6, die erste Seitenwand 7 und die zweite Seitenwand 8 von einem Substratbehälter 201 beabstandet sind, der auf der Trägereinheit 14 in der vorgegebenen Position abgesetzt ist.

Zum Anheben und Absenken der Trägereinheit 14 ist eine Hubeinheit 23 vorgesehen. Die Hubeinheit 23 weist eine Führung 24 zur vertikalen Führung einer Hubstange 25 auf. Die Führung 24 ist außerhalb der Ladekammer 2 angeordnet. Die Hubstange 25 erstreckt sich in vertikaler Richtung (y-Koordinate) über eine abgedichtete Durchführung 26 im Boden 3 der Ladekammer 2 in den Innenraum 9 der Ladekammer 2. Auf ihr sitzt die Trägereinheit 14 mit ihrer Unterseite 17 auf. Die Trägereinheit 14 weist einen Schlitten 27 auf, der das Basiselement 15 hält. Der Schlitten 27 läuft in einer vertikalen Führungsschiene 28, die an der Rückwand der Ladekammer 2 angeordnet ist. Mittels der Hubeinheit 23 kann die Trägereinheit 14, die in der Führungsschiene 28 geführt ist, in vertikaler Richtung angehoben und abgesenkt werden (Doppelpfeil A). Dazu weist die Hubeinheit 23 einen Antrieb 38 auf, der außerhalb der Ladekammer 2 angeordnet ist.

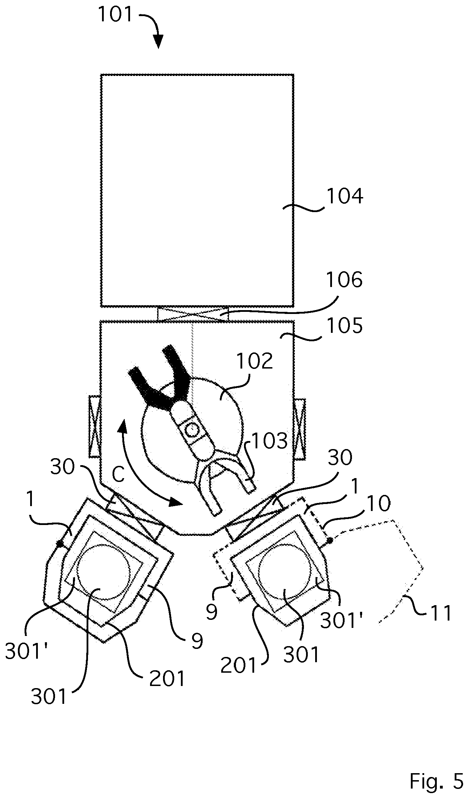

In der Rückwand 5 der Ladekammer 2 ist eine Schleusenöffnung 29 ausgebildet, die den Transfer eines Substrates 301 aus einem geöffneten Substratbehälter 201, der sich in der Ladekammer 2 befindet, in eine Vorrichtung 101 zur Bearbeitung flacher Substrat oder umgekehrt ermöglicht. Die Vorrichtung 101 weist eine Handhabungseinrichtung 102 auf, bei der es sich um einen Roboter mit einem Greifarm 103 handeln kann (siehe Fig. 5). Der Greifarm 103 kann zum Transfer eines Substrates 301 durch die Schleusenöffnung 29 in den geöffneten Substratbehälter 201 geführt werden, um dort ein Substrat 301 abzulegen oder aufzunehmen. Die Schleusenöffnung 29 ist in der geometrischen Mitte der Rückwand 5 angeordnet. Die Schleusenöffnung 29 ist mittels eines Schleusenventils 30 verschlossen. Zum Transfer eines Substrates 301 aus der Ladekammer 2 in die Vorrichtung 101 und aus der Vorrichtung 101 in die Ladekammer 2 wird das Schleusenventil 30 geöffnet.

Die Ladeschleuse 1 weist ferner eine Öffnungsmechanik 31 auf, mit der der Substratbehälter-Deckel 207 von der Zugangsöffnung 206 abgenommen und auf die Zugangsöffnung 206 aufgesetzt werden kann. Die Öffnungsmechanik 31 ist in der Ladekammer oberhalb der Schleusenöffnung 29 angeordnet. Die Öffnungsmechanik 31 weist Eingriffsmittel 32 auf, die in Eingriff mit den Ausnehmungen 209, die im Deckel 207 ausgebildet sind, gebracht werden können. Dabei können die Eingriffsmittel 32 mit einem Verriegelungsmechanismus zusammenwirken, der die Eingriffsmittel 32 in den Ausnehmungen 209 blockiert oder die dort blockierten Eingriffsmittel 32 entsperrt. Die Öffnungsmechanik 31 weist Führungsmittel 33 für die Eingriffsmittel 32 auf. Mittels der Führungsmittel können die Eingriffsmittel - und mit ihnen der Deckels 207, wenn die Eingriffsmittel 32 in den Ausnehmungen 209 des Deckel 207 blockiert sind - in horizontaler Richtung (Doppelpfeil B) bewegt werden. Die Führungsmittel 33 sind durch Durchführungen 34 geführt, die in der Rückwand 5 der Ladekammer 2 ausgebildet sind. Der Öffnungsmechanismus 31 weist Antriebe 36 auf, die außerhalb der Ladekammer 2 angeordnet sind.

Die Ladekammer 2 weist einen oder mehrere Anschlüsse 37 auf, über die mittels eines Druckeinstellmittels (nicht gezeigt) in der Ladekammer 2 eine Druck p₂ eingestellt werden kann, der sich von dem Umgebungsdruck p₁, in der Regel atmosphärischer Druck, unterscheidet.

An der Rückwand 5 der Ladekammer 2 ist eine Identifizierungseinrichtung 39 in Form eines Sensors angeordnet und zwar oberhalb der Schleusenöffnung 29 und unterhalb der Öffnungsmechanik 31. Mittels der Identifizierungseinrichtung 39 können der Substratbehälter 201, der sich in der Ladekammer 2 befindet, und/oder die Substrate 301, die sich in dem Substratbehälter befinden, identifiziert werden.

Die Ladeschleuse 2 ist an einer Vorrichtung 101 zur Bearbeitung flacher Substrate angebracht. Die Vorrichtung 101 ist eine Druckprozessanlage. Sie weist eine Prozesskammer 104 auf, in der flache Substrate bearbeitet werden können. Die Prozesskammer 104 ist mit einer Handhabungskammer 105 über eine Schleuse 106 verbunden. An der Handhabungskammer 105 sind zwei erfindungsgemäße Ladeschleusen 1 angeordnet. Dabei sind die Schleusenöffnungen 29 fluchtend zu Öffnungen der Handhabungskammer 105 angeordnet. In der Handhabungskammer 105 befindet sich die Handhabungseinrichtung 102 mit ihrem Greifarm 103. Mittels der Handhabungseinrichtung 102 kann ein Substrat 301 aus einer der Ladeschleusen 1 entnommen und in die Prozesskammer 104 überführt werden und umgekehrt. Dazu kann sich die Handhabungseinrichtung 102 mit dem von dem Greifarm 103 gehaltenen Substrat 301 innerhalb der Handhabungskammer 105 um eine vertikale Achse drehen (Doppelpfeil C). In Fig. 5 ist in beiden Ladeschleusen 1 zusätzlich zu einem flachen Substrat 301, das einen kreisförmigen Querschnitt aufweist, ein flaches Substrat 301' mit quadratischem Querschnitt gezeigt.

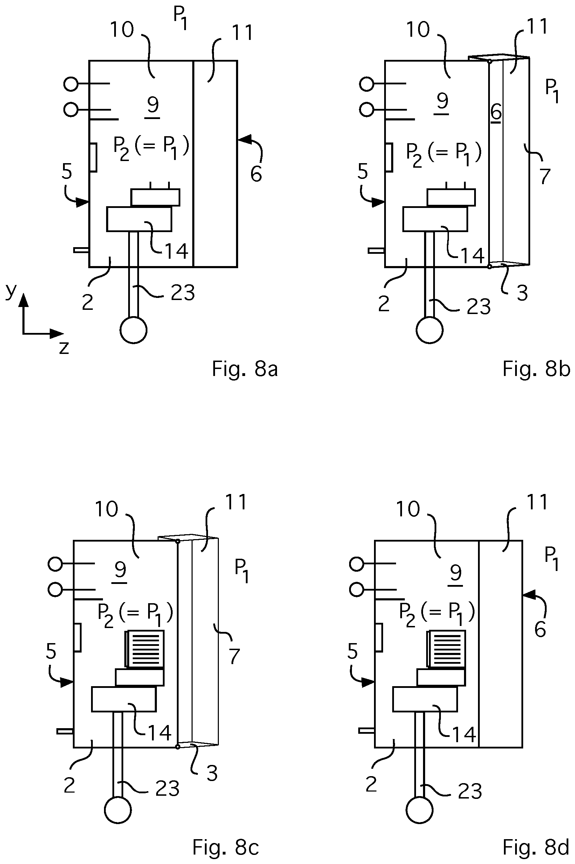

Die Figuren 8a bis 8m veranschaulichen eine Ausführungsform des erfindungsgemäßen Verfahrens. Dabei ist die Ladeschleuse 2 jeweils stark vereinfacht dargestellt. Im gezeigten Beispiel wird von einer leeren Ladekammer 2 ausgegangen, in die ein Substratbehälter 201 eingebracht werden soll, der Substrate 301 enthält. Die Ladekammer 2 ist zunächst also leer und geschlossen (Fig. 8a). Die Oberseite der Trägereinheit 14 befindet sich in einer Ausgangsposition, d. h. in einer Höhe, bezogen auf die vertikale Koordinate y, die annähernd der halben Höhe des Innenraums 9 der Ladekammer 2 entspricht. Die Ausgangsposition entspricht in diesem Beispiel einer Transferposition, d. h. einer Lage, die einen Transfer eines Substrates 301 aus einem Substratbehälter 201 ermöglicht, wenn sich ein geöffneter Substratbehälter 201 auf der Oberseite der Trägereinheit 14 befände. Der Druck p₂ in der Ladekammer entspricht dem Umgebungsdruck p₁.

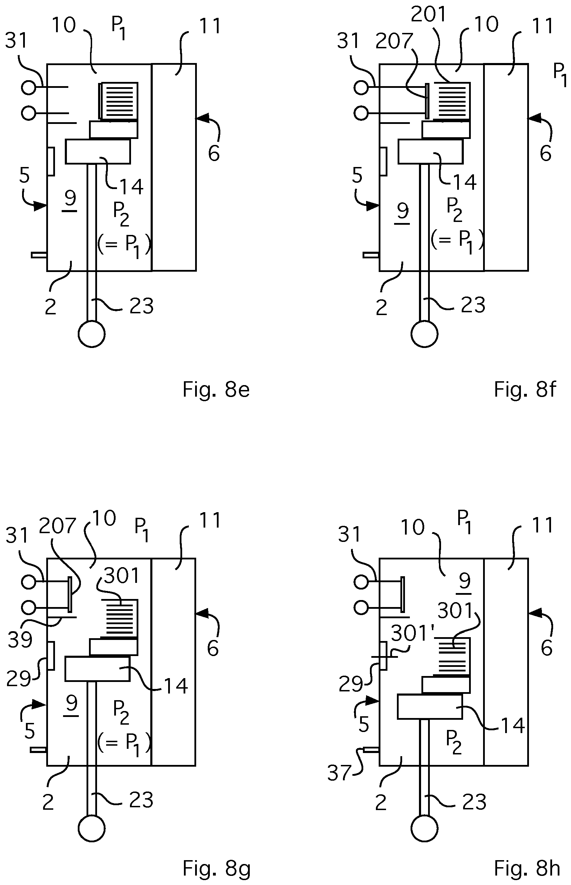

Die Ladekammer 2 wird nun geöffnet (Fig. 8b). Dazu wird die Ladekammer 2 entlang der Teilungsebene in einen ersten Teil 10 und einen zweiten Teil 11 getrennt. Anschließend wird ein Substratbehälter 201, der Substrate 301 enthält, auf der Trägereinheit 14 abgesetzt (Fig. 8c), so dass er sich in einer vorgegebenen Position auf der Trägereinheit 14 befindet. Die Ladekammer 2 wird nun in ihren geschlossenen Zustand überführt (Fig. 8d), indem der zweite Teil 11 wieder mit dem ersten Teil 10 zusammengeführt wird. Anschließend kann der Substratbehälter 201 aus der Ausgangsposition entlang einer vertikaler Achse in die Öffnungs- und Verschlussposition angehoben werden (Fig. 8e, siehe auch Pfeil A in Fig. 6). In der Öffnungs- und Verschlussposition wird mittels der Öffnungsmechanik 31 der Deckel 207 von dem Substratbehälter 201 abgenommen (Fig. 8f) und bis zum Wiederaufbringen von der Öffnungsmechanik 31gehalten (siehe Pfeil B in Fig. 6). Nach dem Abnehmen des Deckels 207 ist der Innenraum des Substratbehälters nunmehr zugänglich und steht für eine zumindest näherungsweise Anpassung des Druckes an den Druck in der Prozesskammer der Druckprozessanlage 101 bereit. Der geöffnete Substratbehälter 201 wird aus der Öffnungs- und Verschlussposition in die Identifizierungsposition abgesenkt (Fig. 8g). Dort können der Substratbehälter 201 und/oder die in ihm enthaltenen Substrate 301 mittels der Identifizierungseinrichtung 39 identifiziert werden. Anschließend wird der Druckausgleich vorgenommen. Dabei wird über den Anschluss 37 in der Ladekammer 2 ein Druck p₂ eingestellt, der sich von dem Umgebungsdruck p₁ unterscheidet. Der Druck p₂ liegt zumindest näherungsweise in der gleichen Größenordnung wie Druck, bei dem in der Druckprozessanlage 101 die Bearbeitung des Substrates 301 erfolgen soll. Eine exakte Druckregelung kann separat in der absperrbaren Prozesskammer 104 stattfinden.

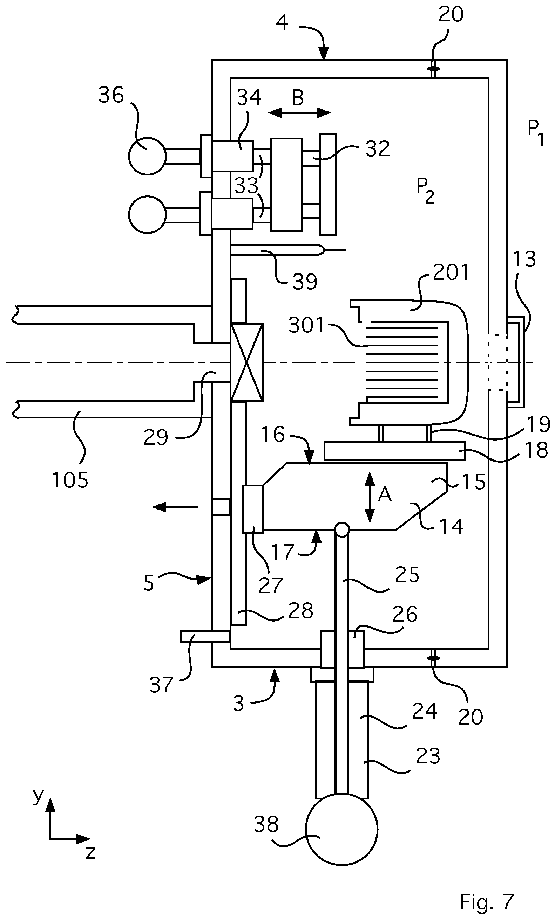

Nach dem Druckausgleich wird der geöffnete Substratbehälter 201 aus der Identifizierungsposition in eine Transferposition abgesenkt (Fig. 8h, siehe auch Fig. 7). In der Transferposition liegt ein Substrat 301', das aus dem Substratbehälter 201 entnommen werden soll, in Höhe der Schleusenöffnung 29. Das Schleusenventil wird geöffnet, wodurch die Schleusenöffnung 29 offensteht. Das Substrat 301' wird nun durch das geöffnete Schleusenventil 30 und damit durch die Schleusenöffnung 29 in die Handhabungskammer 105 (nicht gezeigt) bewegt.

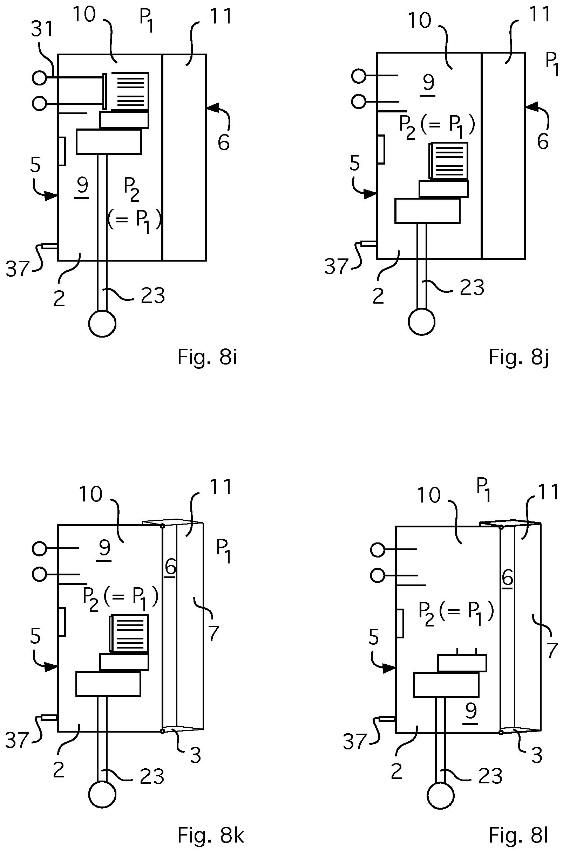

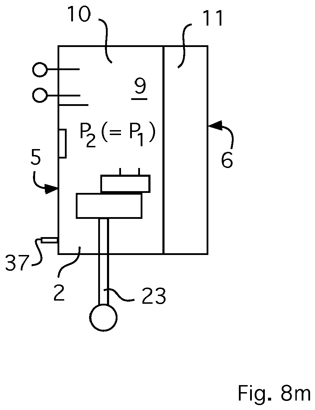

Sollen weitere Substrate 301 aus dem Substratbehälter 201 entnommen werden, muss der Substratbehälter 201 in Transferpositionen überführt werden, in denen das jeweilige Substrat in Höhe der Schleusenöffnung 29 liegt. Das ist Fig. 8 jedoch nicht gezeigt. Die an Fig. 8h anschließenden Figuren zeigen die weitere Vorgehensweise, wenn der Substratbehälter 201, aus dem soeben das Substrat 301' entnommen wurde, aus der Ladeschleuse 2 entnommen werden soll. Dazu wird das Schleusenventil 30 geschlossen, so dass ein erneuter Druckausgleich möglich ist. Dabei wird der Druck p₂ wieder auf den Umgebungsdruck p₁ gebracht. Anschließend wird der Substratbehälter 201 aus der Transferposition in die Öffnungs- und Verschlussposition angehoben und der Deckel 207 mittels der Öffnungsmechanik 31 wieder auf den Substratbehälter 201 aufgebracht (Fig. 8i). Der verschlossene Substratbehälter 201 wird dann in die Ausgangsposition abgesenkt (Fig. 8j). Dann wird die Ladekammer 2 geöffnet, indem sie entlang der Teilungsebene in einen ersten Teil 10 und einen zweiten Teil 11 geteilt wird (Fig. 8k). Der Substratbehälter 201 wird dann aus der Ladekammer 2 entnommen (Fig. 81). Nach dem Schließen der Ladekammer wird der in Fig. 8a gezeigte Zustand erhalten (Fig. 8m).

Die Figuren 6 und 7 zeigen die erfindungsgemäße Ladeschleuse in Verbindung mit einem Teil der Handhabungskammer 105. Dies ist jedoch kein Teil der Ladeschleuse 2. Vielmehr wird ein Teil der Handhabungskammer 105 gezeigt, um zu Veranschaulichen, dass die Schleusenöffnung der Ladekammer 2 an eine Öffnung in der Handhabungskammer 105 angrenzt.

### Bezugszeichenliste

- 1: Ladeschleuse
- 2: Ladekammer
- 3: Boden
- 4: Decke
- 5: Rückwand
- 6: Vorderwand
- 7: erste Seitenwand
- 8: zweite Seitenwand
- 9: Innenraum
- 10: erster Teil
- 11: zweiter Teil
- 12: Gelenk
- 13: Griff
- 14: Trägereinheit
- 15: Basiselement
- 16: Oberseite
- 17: Unterseite
- 18: Verbindungsplatte
- 19: Positionierpin
- 20: Dichtungsmittel
- 21: Kante
- 22: Kante
- 23: Hubeinheit
- 24: Führung
- 25: Hubstange
- 26: Durchführung
- 27: Schlitten
- 28: Führungsschiene
- 29: Schleusenöffnung
- 30: Schleusenventil
- 31: Öffnungsmechanik
- 32: Eingriffsmittel
- 33: Führungsmittel
- 34: Durchführung
- 36: Antrieb
- 37: Anschluss
- 38: Antrieb
- 39: Identifizierungseinrichtung

- 101: Druckprozessanlage
- 102: Handhabungseinrichtung
- 103: Greifarm
- 104: Prozesskammer
- 105: Handhabungskammer
- 106: Schleuse

- 201: Substratbehälter
- 202: Gehäuse
- 203: Boden
- 204: Decke
- 205: Seitenwand
- 206: Zugangsöffnung
- 207: Deckel
- 208: Positionierungsstift
- 209: Ausnehmung

- 301: Substrat

## Patentansprüche

1. Ladeschleuse (1) für einen Substratbehälter (201), der ein Gehäuse (202) mit einem Boden (203), einer Decke (204) sowie Seitenwänden (205) aufweist und zur Aufnahme flacher Substrate (301) bestimmt ist, wobei die Ladeschleuse (1) eine Ladekammer (2) zur Aufnahme des Substratbehälters (201) aufweist, die einen Boden (3), eine Decke (4), eine Rückwand (5), eine Vorderwand (6), eine erste Seitenwand (7) und eine zweite Seitenwand (8), die die Rückwand (5) mit der Vorderwand (6) verbinden, aufweist, und in der Ladekammer (2) eine Trägereinheit (14) zur Aufnahme des Substratbehälters (201) angeordnet ist, wobei die Ladekammer (2) zum Öffnen der Ladekammer (2) entlang einer Teilungsebene (A, B, C, D) in einen ersten Teil (10) und einen zweiten Teil (11) teilbar ist, **dadurch gekennzeichnet, dass** die Teilungsebene (A, B, C, D) in Richtung der Rückwand (5) versetzt zur Vorderwand (6) durch die erste Seitenwand (7), die zweite Seitenwand (8), den Boden (3) und die Decke (4) der Ladekammer (2) verläuft.

2. Ladeschleuse nach Anspruch 1, **dadurch gekennzeichnet, dass** die Ladekammer (2) in einem geschlossenen Zustand gegen die Umgebung abgedichtet ist, wobei die Ladeschleuse (1) Druckeinstellmittel zur Einstellung des Druckes in der Ladekammer (2) aufweist.

3. Ladeschleuse nach Anspruch 1 oder Anspruch 2, **dadurch gekennzeichnet, dass** sie eine Hubeinheit (23) zum Anheben und Absenken der Trägereinheit (14) aufweist.

4. Ladeschleuse nach Anspruch 3, **dadurch gekennzeichnet, dass** die Trägereinheit (14) einen Schlitten (27) aufweist, der von einem Führungsmittel (28) geführt ist.

5. Ladeschleuse nach Anspruch 4, **dadurch gekennzeichnet, dass** das Führungsmittel (28) an der Rückwand (5) der Ladekammer (2) angeordnet ist.

6. Ladeschleuse nach Anspruch 5, **dadurch gekennzeichnet, dass** im Boden (3) der Ladekammer (2) eine Durchführung (26) für die Hubeinheit (23) zum Anheben und Absenken der Trägereinheit (14) angeordnet ist.

7. Ladeschleuse nach einem der vorstehenden Ansprüche, **dadurch gekennzeichnet, dass** in der Rückwand (5) der Ladekammer (1) eine Schleusenöffnung (29) zum Transfer eines Substrates (301) aus der oder in die Ladekammer (2) ausgebildet ist, wobei die Schleusenöffnung (29) mittels eines Schleusenventils (30) verschließbar ist.

8. Ladeschleuse nach einem der vorstehenden Ansprüche, **dadurch gekennzeichnet, dass** sie eine Öffnungsmechanik (31) zum Abnehmen und Aufsetzen des Substratbehälter-Deckels (207) aufweist.

9. Ladeschleuse nach Anspruch 8, **dadurch gekennzeichnet, dass** die Öffnungsmechanik (31) oberhalb oder unterhalb der Schleusenöffnung (29) angeordnet ist.

10. Ladeschleuse nach einem der Ansprüche 3 bis 9, **dadurch gekennzeichnet, dass** die Hubeinheit (23) eine Hubeinheit zum Anheben oder Absenken der Trägereinheit (14) in zumindest eine der folgenden Positionen ist:
- eine Öffnungs- und Verschlussposition, in der sich die Oberseite der Trägereinheit (14) in einer Lage befindet, die es der Öffnungsmechanik (31) ermöglicht, den Substratbehälter-Deckel (207) eines Substratbehälters (201), der sich auf der Oberseite der Trägereinheit (14) befindet, abzunehmen oder aufzusetzen;
- eine Transferposition, in der sich die Oberseite der Trägereinheit (14) in einer Lage befindet, die einen Transfer eines Substrates (301) aus einem oder in einen Substratbehälter (201) ermöglicht, der sich auf der Oberseite der Trägereinheit (14) befindet.

11. Ladeschleuse nach einem der vorstehenden Ansprüche, **dadurch gekennzeichnet, dass** sie eine Identifizierungseinrichtung (39) zur Identifizierung von Substraten (301), die sich in dem Substratbehälter (201) befinden, aufweist.

12. Ladeschleuse nach Anspruch 11, **dadurch gekennzeichnet, dass** die Identifizierungseinrichtung (39) an der Rückwand (5) der Ladekammer (2) angeordnet ist.

13. Ladeschleuse nach Anspruch 10 oder Anspruch 11, **dadurch gekennzeichnet, dass** die Hubeinheit (23) eine Hubeinheit zum Anheben oder Absenken der Trägereinheit (14) in eine Identifizierungsposition ist, wobei sich in der Identifizierungsposition die Oberseite der Trägereinheit (14) in einer Lage befindet, in der die Identifizierungseinrichtung (39) ein Substrat (301) in einem Substratbehälter (201), der sich auf der Oberseite der Trägereinheit (14) befindet, identifizieren kann.

14. Vorrichtung (101) zum Bearbeiten von flachen Substraten (301), aufweisend
- eine Prozesskammer (104) zur Bearbeitung eines oder mehrerer flacher Substrate (301);
- eine Ladeschleuse (1) gemäß einem der Ansprüche 1 bis 13;
- eine Handhabungseinrichtung (102) zum Transfer eines oder mehrerer Substrate (301) zwischen einem Substratbehälter (201), der von der Trägereinheit (14) aufgenommen ist, und der Prozesskammer (104) durch die Schleusenöffnung (29) der Ladekammer (2).

15. Verfahren zum Betrieb einer Ladeschleuse gemäß einem der Ansprüche 1 bis 13, umfassend die Schritte:
(a) Öffnen der Ladekammer (2) durch Teilen in den ersten (10) und den zweiten Teil (11);
(b) Absetzen eines Substratbehälters (201) auf der Trägereinheit (14);
(c) Schließen der Ladekammer (2) durch Zusammenfügen des ersten (10) und des zweiten Teils (11);
(d) Abnehmen des Deckels (207) des Substratbehälters (201) mittels einer Öffnungsmechanik (31); und
(e) Entnahme zumindest eines Substrates (301) aus dem Substratbehälter (201);
wobei zur Ausführung der Schritte (d) und (e) die Trägereinheit (14) mittels einer Hubeinheit (23) zum Anheben oder Absenken der Trägereinheit (14) von
- einer Öffnungs- und Verschlussposition, in der sich die Oberseite der Trägereinheit (14) in einer Lage befindet, die es der Öffnungsmechanik (31) ermöglicht, den Substratbehälter-Deckel (207) eines Substratbehälters (201), der sich auf der Oberseite der Trägereinheit (14) befindet, abzunehmen oder aufzusetzen; in
- eine Transferposition, in der sich die Oberseite der Trägereinheit (14) in einer Lage befindet, die einen Transfer eines Substrates (301) aus einem Substratbehälter (201) ermöglicht, der sich auf der Oberseite der Trägereinheit (14) befindet;
bewegt wird.

16. Verfahren nach Anspruch 15, **dadurch gekennzeichnet, dass** nach dem Öffnen des Substratbehälters (201) in Schritt (d) in der Ladekammer (2) ein Druck eingestellt wird, der sich von dem Umgebungsdruck unterscheidet.

## Claims

1. A load lock (1) for a substrate container (201) having a housing (202) that has a bottom (203), a ceiling (204) as well as side walls (205) and being intended for receiving flat substrates (301), wherein the load lock (1) has a load chamber (2) for receiving the substrate container (201) that has a bottom (3), a ceiling (4), a rear wall (5), a front wall (6), a first side wall (7) and a second side wall (8) that connect the rear wall (5) to the front wall (6), and wherein a carrier unit (14) for receiving the substrate container (201) is arranged in the load chamber (2), wherein the load chamber (2) can be divided into a first part (10) and a second part (11) along a dividing plane (A, B, C, D) to open the load chamber (2), **characterized in that** the dividing plane (A, B, C, D) extends toward the rear wall (5) offset from the front wall (6) through the first side wall (7), the second side wall (8), the bottom (3) and the ceiling (4) of the load chamber (2).

2. The load lock according to claim 1, **characterized in that** the load chamber (2) in a closed state is sealed against the environment, wherein the load lock (1) has pressure adjusting means for adjusting the pressure in the load chamber (2).

3. The load lock according to claim 1 or claim 2, **characterized in that** it has a lifting unit (23) for lifting and lowering the carrier unit (14).

4. The load lock according to claim 3, **characterized in that** the carrier unit (14) has a slide (27) guided by a guide means (28).

5. The load lock according to claim 4, **characterized in that** the guide means (28) is arranged on the rear wall (5) of the load chamber (2).

6. The load lock according to claim 5, **characterized in that** a bushing (26) for the lifting unit (23) for lifting and lowering the carrier unit (14) is arranged in the bottom (3) of the load chamber (2).

7. The load lock according to any one of the preceding claims, **characterized in that** a lock opening (29) for transferring a substrate (301) out of or into the load chamber (2) is formed in the rear wall (5) of the load chamber (2), wherein the lock opening (29) can be closed by means of a lock valve (30).

8. The load lock according to any one of the preceding claims, **characterized in that** it has an opening mechanism (31) for taking off and putting on the substrate container lid (207).

9. The load lock according to claim 8, **characterized in that** the opening mechanism (31) is arranged above or below the lock opening (29).

10. The load lock according to any one of claims 3 to 9, **characterized in that** the lifting unit (23) is a lifting unit for lifting or lowering the carrier unit (14) to at least one of the following positions:
- an opening and closing position where the upper surface of the carrier unit (14) is in a position that enables the opening mechanism (31) to take off or put on the substrate container lid (207) of a substrate container (201) that is on the upper surface of the carrier unit (14);
- a transfer position where the upper surface of the carrier unit (14) is in a position that enables transfer of a substrate (301) out of or into a substrate container (201) that is on the upper surface of the carrier unit (14).

11. The load lock according to any one of the preceding claims, **characterized in that** it has an identification system (39) for identifying substrates (301) that are present in the substrate container (201).

12. The load lock according to claim 11, **characterized in that** the identification system (39) is arranged on the rear wall (5) of the load chamber (2).

13. The load lock according to claim 10 or claim 11, **characterized in that** the lifting unit (23) is a lifting unit for lifting or lowering the carrier unit (14) to an identification position, wherein in the identification position the upper surface of the carrier unit (14) is in a position where the identification system (39) can identify a substrate (301) in a substrate container (201) that is present on the upper surface of the carrier unit (14).

14. A device (101) for processing flat substrates (301) having
- a process chamber (104) for processing one or more flat substrates (301);
- a load lock (1) according to any one of claims 1 to 13;
- a handling system (102) for transferring one or more substrates (301) between a substrate container (201) received by the carrier unit (14) and the process chamber (104) through the lock opening (29) of the load chamber (2).

15. A method for operating a load lock according to any one of claims 1 to 13 comprising the steps of:
(a) opening the load chamber (2) by dividing it into the first (10) and the second part (11);
(b) putting a substrate container (201) onto the carrier unit (14);
(c) closing the load chamber (2) by joining the first (10) and the second part (11);
(d) taking off the lid (207) from the substrate container (201) by means of an opening mechanism (31); and
(e) taking at least one substrate (301) out of the substrate container (201);
wherein for carrying out steps (d) and (e) the carrier unit (14) by means of a lifting unit (23) for lifting or lowering the carrier unit (14) is moved from
- an opening and closing position where the upper surface of the carrier unit (14) is in a position that enables the opening mechanism (31) to take off or put on the substrate container lid (207) of a substrate container (201) that is present on the upper surface of the carrier unit (14); to
- a transfer position where the upper surface of the carrier unit (14) is in a position that enables a substrate (301) to be transferred from a substrate container (201) that is present on the upper surface of the carrier unit (14).

16. The method according to claim 15, **characterized in that** upon opening of the substrate container (201) in step (d) a pressure is set in the load chamber (2) that differs from the environmental pressure.

## Revendications

1. Sas de chargement (1) pour un conteneur de substrat (201) composé d'un boîtier (202) avec un fond (203), un plafond (204) ainsi que des parois latérales (205) et destiné à recevoir des substrats plats (301), le sas de chargement (1) présentant une chambre de chargement (2) destinée à recevoir le conteneur de substrat (201), qui présente un fond (3), un plafond (4), une paroi arrière (5), une paroi avant (6), une première paroi latérale (7) et une deuxième paroi latérale (8), qui relient la paroi arrière (5) à la paroi avant (6), et une unité de support (14) destinée à recevoir le conteneur de substrat (201) est disposée dans la chambre de chargement (2), la chambre de chargement (2) pouvant être divisée en une première partie (10) et une deuxième partie (11) le long d'un plan de division (A, B, C, D) pour ouvrir la chambre de chargement (2), **caractérisé en ce que** le plan de division (A, B, C, D) s'étend dans la direction de la paroi arrière (5) décalée par rapport à la paroi avant (6) à travers la première paroi latérale (7), la deuxième paroi latérale (8), le fond (3) et le plafond (4) de la chambre de chargement (2).

2. Sas de chargement selon la revendication 1, **caractérisé en ce que** la chambre de chargement (2) est rendue étanche par rapport à l'environnement dans un état fermé, le sas de chargement (1) présentant des moyens de réglage de la pression pour le réglage de la pression dans la chambre de chargement (2).

3. Sas de chargement selon la revendication 1 ou la revendication 2, **caractérisé en ce qu'**il comporte une unité de levage (23) pour soulever et abaisser l'unité de support (14).

4. Sas de chargement selon la revendication 3, **caractérisé en ce que** l'unité de support (14) présente un chariot (27) guidé par un moyen de guidage (28).

5. Sas de chargement selon la revendication 4, **caractérisé en ce que** le moyen de guidage (28) est disposé sur la paroi arrière (5) de la chambre de chargement (2).

6. Sas de chargement selon la revendication 5, **caractérisé en ce que** dans le fond (3) de la chambre de chargement (2) est disposé un passage (26) pour l'unité de levage (23) pour soulever et abaisser l'unité de support (14).

7. Sas de chargement selon l'une des revendications précédentes, **caractérisé en ce qu'**une ouverture de sas (29) est formée sur la paroi arrière (5) de la chambre de chargement (1) pour le transfert d'un substrat (301) hors de ou dans la chambre de chargement (2), l'ouverture de sas (29) pouvant être fermée au moyen d'une vanne de sas (30).

8. Sas de chargement selon l'une des revendications précédentes, **caractérisé en ce qu'**il comporte un mécanisme d'ouverture (31) pour retirer et mettre en place le couvercle (207) du conteneur de substrat.

9. Sas de chargement selon la revendication 8, **caractérisé en ce que** le mécanisme d'ouverture (31) est disposé au-dessus ou en dessous de l'ouverture du sas (29).

10. Sas de chargement selon l'une des revendications 3 à 9, **caractérisé en ce que** l'unité de levage (23) est une unité de levage pour soulever ou abaisser l'unité de support (14) dans au moins une des positions suivantes :
- une position d'ouverture et de fermeture dans laquelle la face supérieure de l'unité de support (14) est dans une position qui permet au mécanisme d'ouverture (31) d'enlever ou de mettre en place le couvercle (207) de conteneur de substrat d'un conteneur de substrat (201) qui est situé sur la face supérieure de l'unité de support (14) ;
- une position de transfert dans laquelle la surface supérieure de l'unité de support (14) est dans une position permettant le transfert d'un substrat (301) depuis ou dans un conteneur de substrat (201) situé sur la surface supérieure de l'unité de support (14).

11. Sas de chargement selon l'une des revendications précédentes, **caractérisé en ce qu'**il comprend un dispositif d'identification (39) pour identifier les substrats (301) présents dans le conteneur de substrats (201).

12. Sas de chargement selon la revendication 11, **caractérisé en ce que** le dispositif d'identification (39) est disposé sur la paroi arrière (5) de la chambre de chargement (2).

13. Sas de chargement selon la revendication 10 ou la revendication 11, **caractérisé en ce que** l'unité de levage (23) est une unité de levage pour soulever ou abaisser l'unité de support (14) dans une position d'identification, dans laquelle, dans la position d'identification, la face supérieure de l'unité de support (14) est dans une position dans laquelle le dispositif d'identification (39) peut identifier un substrat (301) dans un conteneur de substrat (201) situé sur la face supérieure de l'unité de support (14).

14. Dispositif (101) pour le traitement de substrats plats (301), comprenant
- une chambre de processus (104) pour le traitement d'un ou plusieurs substrats plats (301) ;
- un sas de chargement (1) selon l'une des revendications 1 à 13 ;
- un dispositif de manipulation (102) pour transférer un ou plusieurs substrats (301) entre un conteneur de substrat (201) reçu par l'unité de support (14) et la chambre de traitement (104) à travers l'ouverture de sas (29) de la chambre de chargement (2).

15. Procédé de fonctionnement d'un sas de chargement selon l'une des revendications 1 à 13, comprenant les étapes :
(a) ouvrir la chambre de chargement (2) en la divisant en la première (10) et la deuxième (11) partie ;
(b) déposer un récipient de substrat (201) sur l'unité de support (14) ;
(c) fermer la chambre de chargement (2) en assemblant la première (10) et la deuxième (11) partie ;
(d) retirer le couvercle (207) du conteneur de substrat (201) au moyen d'un mécanisme d'ouverture (31) ; et
(e) retirer au moins un substrat (301) du conteneur de substrat (201) ;
dans lequel, pour l'exécution des étapes (d) et (e), l'unité de support (14), au moyen d'une unité de levage (23) pour soulever ou abaisser l'unité de support (14), est déplacée
- d'une position d'ouverture et de fermeture dans laquelle la face supérieure de l'unité de support (14) se trouve dans une position permettant au mécanisme d'ouverture (31) d'enlever ou de mettre en place le couvercle (207) de conteneur de substrat d'un conteneur de substrat (201) qui est situé sur la face supérieure de l'unité de support (14) ; dans
- une position de transfert dans laquelle la surface supérieure de l'unité de support (14) est dans une position permettant le transfert d'un substrat (301) depuis un conteneur de substrat (201) situé sur la surface supérieure de l'unité de support (14).

16. Procédé selon la revendication 15, **caractérisé en ce qu'**après l'ouverture du conteneur de substrat (201) à l'étape (d), une pression différente de la pression ambiante est réglée dans la chambre de chargement (2).
